# EUROPEAN PATENT APPLICATION

(11) **EP 4 447 102 A2**
(43) Date of publication of application: **16.10.2024**
(21) Application number: 24163368.4
(22) Date of filing: 13.03.2024
(51) Int. Cl.: H01L 23/14, H01L 23/00, H01L 25/07

(54) **HEMT PACKAGE WITH BOND WIRE-FREE CONNECTIONS**

(30) Priority: 13.04.2023 US 202318134353
(71) Applicant: Infineon Technologies AG, 85579 Neubiberg (DE)
(72) Inventor: ACUNA, Javier, 59494 Soest (DE)
(74) Representative: Infineon Patent Department

(57) **Abstract**

A semiconductor package includes a metal baseplate, first and second HEMT dies each including a main surface with source, drain and gate terminals disposed thereon, a plurality of metal package terminals, and an encapsulant body of electrically insulating material, wherein the first and second HEMT dies are mounted on the metal baseplate with the main surfaces from each of the first and second HEMT dies facing away from the metal baseplate, wherein the encapsulant body encapsulates the first and second HEMT dies, wherein outer ends from each of the metal package terminals are exposed from the encapsulant body, and wherein each of the source, drain and gate terminals from the first and second HEMT dies is electrically connected via a bond wire-free connection to at least one of the metal package terminals.

## Description

### TECHNICAL FIELD

The present invention relates to a semiconductor package, in particular to a semiconductor package comprising a high-electron-mobility field effect transistors die.

### BACKGROUND

HEMTs (high-electron-mobility Field Effect Transistors) also known as heterostructure FETs (HFETs) and modulation-doped FETs (MODFETs) refer to transistor devices that include a two-dimensional charge carrier gas channel formed from a heterojunction between layers of type III-V semiconductor. This device concept offers very low on-resistance in comparison to other device technologies. Thus, discrete HEMT devices are popular choices for switching devices in power switching applications, i.e., applications that require voltage ratings of 250V, 500V, 1000V, etc. or greater, and/or current ratings of 1A, 5A, 10A, etc. or greater. The semiconductor package used to contain and protect discrete HEMT devices represents an important design consideration that impacts cost and performance of the assembly. There is a need to provide high performance and low-cost packaging solutions for HEMT devices.

### SUMMARY

A semiconductor package is disclosed. According to an embodiment, the semiconductor package comprises a metal baseplate; first and second HEMT (high electron mobility transistor) dies each comprising a main surface with source, drain and gate terminals disposed thereon; a plurality of metal package terminals; and an encapsulant body of electrically insulating material, wherein the first and second HEMT dies are mounted on the metal baseplate with the main surfaces from each of the first and second HEMT dies facing away from the metal baseplate, wherein the encapsulant body encapsulates the first and second HEMT dies, wherein outer ends from each of the metal package terminals are exposed from the encapsulant body, and wherein each of the source, drain and gate terminals from the first and second HEMT dies is electrically connected via a bond wire-free connection to at least one of the metal package terminals.

According to another embodiment, the semiconductor package comprises a first metal baseplate; first and second HEMT (high electron mobility transistor) dies each comprising a main surface with source, drain and gate terminals disposed thereon; a plurality of planar metal leads; and an encapsulant body of electrically insulating material, wherein the first HEMT die is mounted on the first metal baseplate with the main surface of the first HEMT die facing away from the first metal baseplate, wherein the second HEMT die is arranged over the first HEMT die with the main surface of the second HEMT die facing the main surface of the first HEMT die, wherein the encapsulant body encapsulates the first and second HEMT dies, and wherein outer ends from each of the planar metal leads are exposed from the encapsulant body, and wherein each of the source, drain and gate terminals from the first and second HEMT dies is electrically connected via a bond wire-free connection to at least one of the planar metal leads.

A method of forming a semiconductor package is disclosed. According to an embodiment, the method comprises providing a first metal baseplate; providing a first HEMT die comprising a main surface with source, drain and gate terminals disposed thereon; mounting the first HEMT die on the first metal baseplate with the main surface from the first HEMT die facing away from first metal baseplate; providing a plurality of metal package terminals; electrically connecting each of the source, drain and gate terminals from the first HEMT die via a bond wire-free connection to at least one of the metal package terminals; and forming an encapsulant body of electrically insulating material that encapsulates the first HEMT die and exposes outer ends of the metal package terminals.

Those skilled in the art will recognize additional features and advantages upon reading the following detailed description, and upon viewing the accompanying drawings.

### BRIEF DESCRIPTION OF THE DRAWINGS

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.

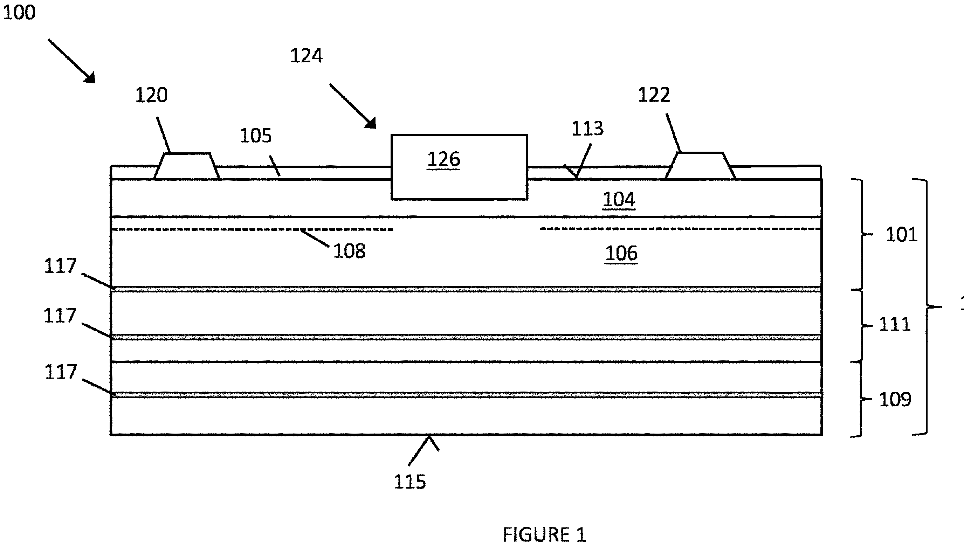

Figure 1 illustrates a HEMT die from a cross-sectional perspective, according to an embodiment.

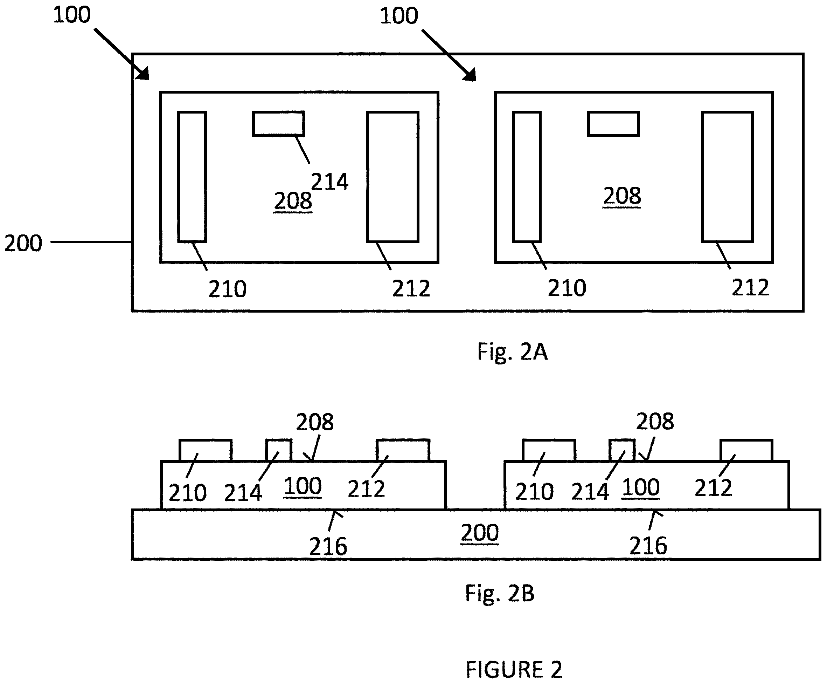

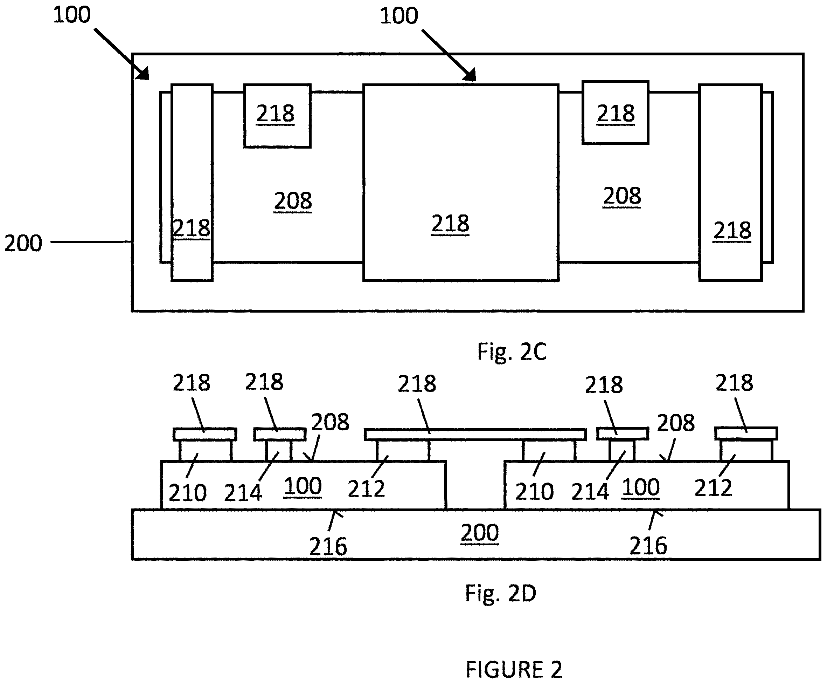

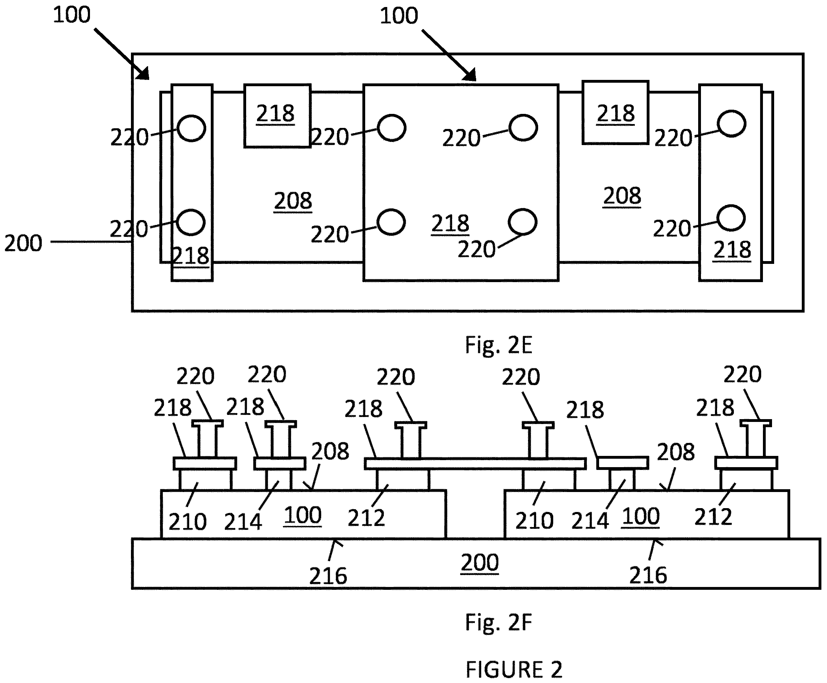

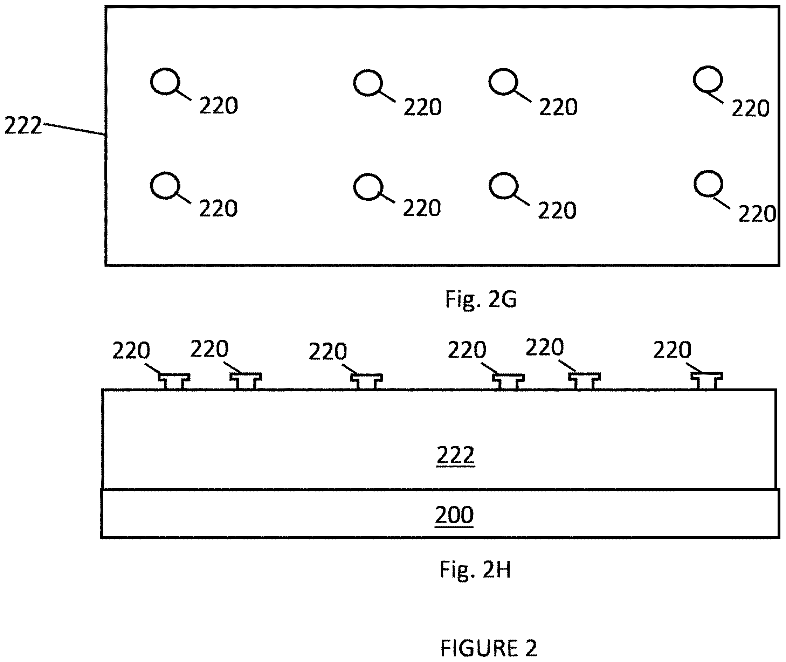

Figure 2, which includes Figs. 2A-2H, illustrates a method of forming a semiconductor package by a bond wire-free connection technique, according to an embodiment. Figs. 2A, 2C, 2E and 2G illustrate plan-views of the assembly during selected method steps and Figs. 2B, 2D, 2E and 2H illustrate corresponding side-views of the assembly during the same method steps.

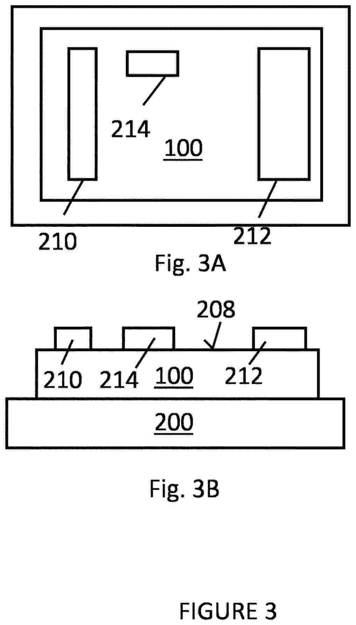

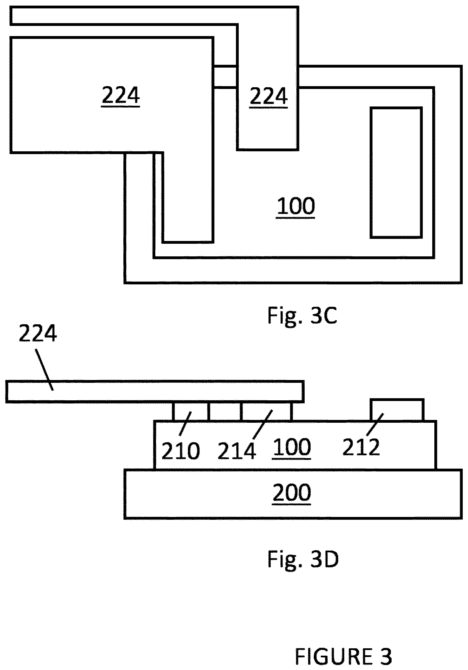

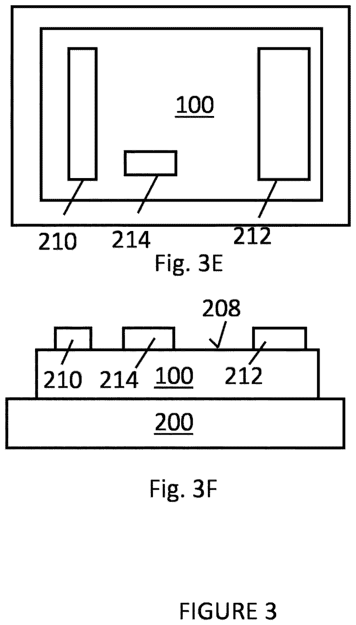

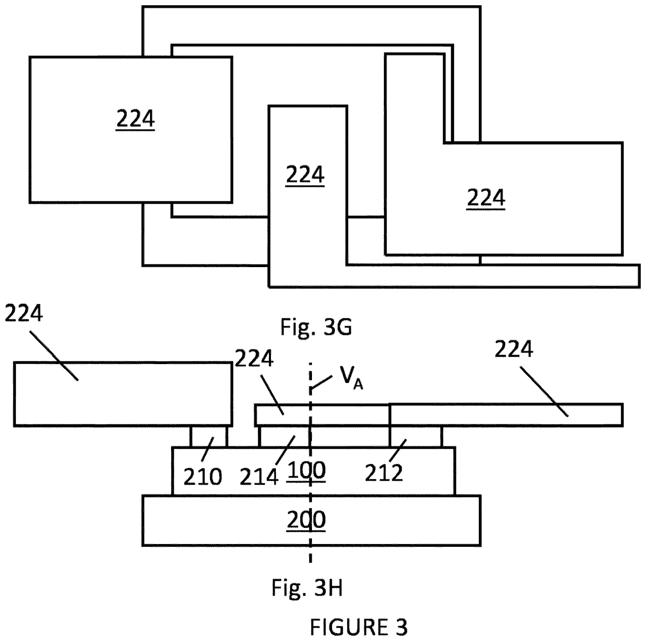

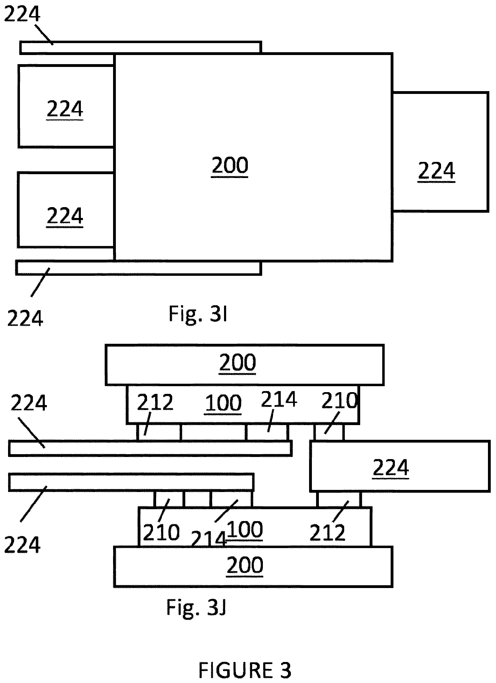

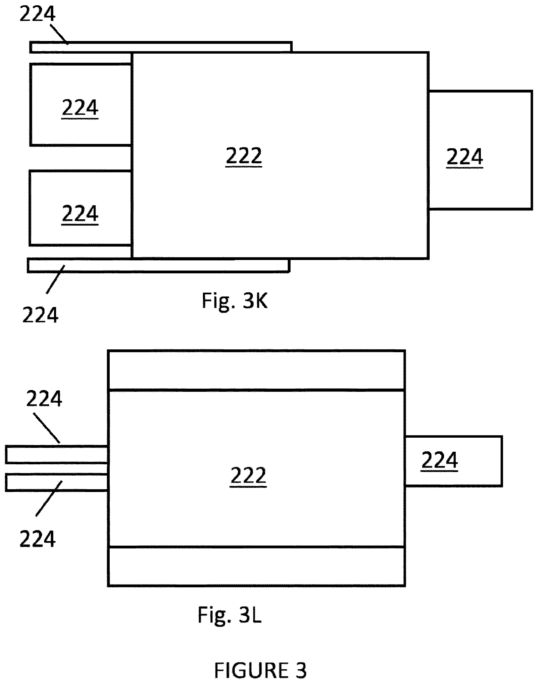

Figure 3, which includes Figs. 3A-3L, illustrates a method of forming a semiconductor package by a bond wire-free connection technique, according to an embodiment. Figs. 3A, 3C, 3E, 3G, 3I, 3K illustrate plan-views of the assembly during selected method steps and Figs. 3B, 3D, 3F, 3H, 3J, and 3L illustrate corresponding side-views of the assembly during the same method steps.

### DETAILED DESCRIPTION

Embodiments of a semiconductor package comprising one or more HEMT dies and a corresponding method of forming the semiconductor package are disclosed herein. Due to a simple carrier structure and a bond wire-free connection technique, the semiconductor package can be produced quickly and inexpensively in comparison to other techniques without sacrificing performance. Power semiconductor packages typically utilize multilayer carrier structures, e.g., PCBs (printed circuit boards), DBCs (direct bonded copper) substrates, IMS (insulated metal) substrates or AMB (active metal brazed) substrates. These multilayer carrier structures include structured metallization layers with insulating regions. By contrast, the carrier structure disclosed herein can be a simple unstructured piece of metal, and thus relatively inexpensive in comparison to a multilayer carrier structure. The HEMT dies of the disclosed embodiments have a lateral device configuration with an electrically inactive rear surface, and thus can be mounted directly on a metal carrier without impacting the function of the HEMT die or creating an electrical short between the HEMT die and another element mounted on the same carrier. Moreover, the external package terminals of the semiconductor package are formed by planar metal structures that are attached directly to the terminals of the HEMT die, thus eliminating the need to use a costly and time-consuming wire-bonding process.

Referring to Figure 1, HEMT die 100 comprises a semiconductor substrate 102. The semiconductor substrate 102 comprises an active channel region 101, which in turn comprises a barrier layer 104 and a channel layer 106 disposed below the barrier layer 104. The barrier layer 104 comprises type III-V semiconductor material and the channel layer 106 comprises type III-V semiconductor material with a different bandgap as the barrier layer 104. For instance, the channel layer 106 can comprise GaN or AlGaN and the barrier layer 104 can comprise AlGaN with a higher aluminum content as the channel layer 106. The channel layer 106 forms a heterojunction with the barrier layer 104 such that a two-dimensional charge carrier gas 108 is disposed in the channel layer 106 near the heterojunction interface. The term two-dimensional charge carrier gas 108 refers to a two-dimensional electron gas ("2DEG") or a two-dimensional hole gas ("2DHG"). In the case that the channel layer 106 is a GaN layer and the barrier layer 104 is a layer of AlGaN, the two-dimensional charge carrier gas 108 is a 2DEG.

The semiconductor substrate 102 additionally comprises a base substrate 109 disposed below the active channel region 101. The base substrate 109 is an inactive part of the semiconductor substrate 102 that is used to epitaxially grow the type III-V semiconductor material for the active channel region 101. The base substrate 109 can correspond to a commercially available semiconductor wafer, e.g., a bulk silicon wafer, a wafer comprising sapphire, SiC, ceramic, or an SOI (silicon on insulator) substrate wafer.

The semiconductor substrate 102 additionally comprises an intermediate region 111 arranged between the active channel region 101 and the base substrate 109. The intermediate region 111 may include multiple different layers of semiconductor and/or insulating material. For example, the intermediate region 111 may comprise a lattice transition region formed from type III-V semiconductor layers with varying crystalline properties, e.g., multiple layers of AIN/GaN/AIGaN with varying aluminum content and/or with electrically insulating layers, e.g., layers comprising SiO₂ (silicon dioxide), Si₃N₄ (silicon nitride), SiO_{N}X_{Y} (silicon oxynitride), etc., that are arranged to alleviate mechanical stresses in the semiconductor substrate 102 resulting from lattice mismatch between the base substrate 109 and the active channel region 101. Separately or in combination, the intermediate region 111 may comprise one or more type III-V semiconductor layers disposed near or interfacing with the channel layer 106, e.g., layers of GaN/AIGaN, that are configured to suppress parasitic channels of the device.

The HEMT die 100 further comprises source and drain electrodes 120, 122 and a gate structure 124 disposed on an upper surface 113 of the semiconductor substrate 102. The source and drain electrodes 120, 122 may be formed from any of a variety of conductive metals such as aluminum, titanium, copper, nickel, tungsten, etc., and any alloys thereof. The gate structure 124 comprises a gate electrode 126 that is formed from an electrical conductor such as a metal, e.g., aluminum, titanium, copper, nickel, tungsten, alloys thereof, etc., or a doped semiconductor, e.g., highly doped monocrystalline or polycrystalline semiconductors. The source and drain electrodes 120, 122 and the gate electrode 126 may be electrically isolated from one another by a first dielectric layer 105 disposed on the upper surface 113 of the semiconductor substrate 102. The first dielectric layer 105 can comprise any of a variety of electrical insulators, such as SiO₂ (silicon dioxide), Si₃N₄ (silicon nitride), SiO_{N}X_{Y} (silicon oxynitride), etc.

The working principle of the HEMT die 100 is as follows. The two-dimensional charge carrier gas 108 is the active channel of the device that conducts a load current between the source and drain electrodes 120, 122. In an on-state of the device, the source and drain electrodes 120, 122 are electrically connected to one another via the two-dimensional charge carrier gas 108. In the off-state of the device, the two-dimensional charge carrier gas 108 is locally disrupted so that the source and drain electrodes 120, 122 are not connected to one another. The device is transitioned between the on-state and the off-state by the application of a gate potential to the gate electrode 126. This influences an electric field beneath the gate, which in turn determines whether the two-dimensional charge carrier gas 108 is locally disrupted. As shown, the gate electrode 126 is disposed within a trench formed in the barrier layer 104. This brings the gate electrode 126 closer to the two-dimensional charge carrier gas 108, thereby enabling better on-off control. The HEMT die 100 may have a variety of different gate configurations, including configurations wherein the gate structure 124 comprises a doped region, e.g., p-type GaN, that is configured to deplete the two-dimensional charge carrier gas 108 and realize a normally-off device configuration.

The HEMT die 100 is configured such that a rear side 115 of the semiconductor substrate 102 is electrically inactive. Because the HEMT die 100 is configured as a lateral device, i.e., a device that is configured to flow the load current parallel to the upper surface 113 of the semiconductor substrate 102, the rear side 115 of the semiconductor substrate 102 of the semiconductor substrate 102 does not require any electrical terminal and may be electrically floating relative to the active channel region 101. In the case that the HEMT die 100 includes a body contact, this contact may be formed in the upper surface 113 of the semiconductor substrate 102. The electrical isolation between the rear side 115 of the semiconductor substrate 102 and the active channel region 101 naturally results from the usage of low-doped material in the base substrate 109. For example, the base substrate 109 may comprise a low-doped semiconductor material, e.g., material with a dopant concentration on the order of 10¹⁵ dopant atoms/cm³, 10¹⁴ dopant atoms/cm^{3,} 10¹³ dopant atoms/cm³, or less, which in essence as an electrical insulator.

According to an embodiment, the electrical isolation between the rear side 115 of the semiconductor substrate 102 and the active channel region 101 is enhanced by the incorporation of one or more intermediate dielectric layers 117 within the semiconductor substrate 102. These intermediate dielectric layers 117 can comprise any of a variety of electrical insulators, such as SiOz (silicon dioxide), Si₃N₄ (silicon nitride), SiO_{X}N_{Y} (silicon oxynitride), etc., and high-K dielectric materials such as HfOz. Figure 1 illustrates three potential locations for the intermediate dielectric layers 117. One of the intermediate dielectric layers 117 may be provided in any one or more of these locations. In a first location, one of the intermediate dielectric layers 117 is provided within the base substrate 109. A particular example of this arrangement is realized by a so-called SOI substrate. In a second location, one of the intermediate dielectric layers 117 is provided within the intermediate region 111. In a third location, one of the intermediate dielectric layers 117 is provided immediately below the active channel region 101.

Referring to Figure 2, selected method steps in a method of forming a semiconductor package by a bond wire-free connection technique are shown, according to an embodiment.

Referring to Figs. 2A and 2B, a method of forming a semiconductor package comprises providing a metal baseplate 200 and mounting first and second HEMT dies 100 on the metal baseplate 200. In the discussion below with reference to Figure 2, the first HEMT die 100 refers to the die on the left of each figure and the second HEMT die 100 refers to the device on the fight of each figure.

The metal baseplate 200 is a solid piece of unstructured metal. Thus, the metal baseplate 200 differs from a multilayer circuit carrier that comprise an electrically insulating substrate and structured metallization layers, e.g., DCB substrates, IMS substrates, AMB substrates, PCBs, etc. The metal baseplate 200 may comprise a core region formed from a thermally conductive metal, e.g., copper, aluminum, steel, and alloys thereof. Optionally, this core region may be covered by one or more plating layers comprising, e.g., Ni, Cu, Al, Ag, Au, Pd, Pt, etc., which may act as adhesion promotors, anti-corrosion layers, etc. The metal baseplate 200 may be provided from an unstructured solid piece of metal, e.g., sheet metal, with only minimal processing being performed, e.g., a simple cutting step,

The first and second HEMT dies 100 each comprise a main surface 208 with source, drain and gate terminals 210, 212, 214 disposed thereon. The first and second HEMT dies 100 are mounted such that the main surfaces 208 face away from the metal baseplate 200 and hence the source, drain and gate terminals 210, 212, 214 face away from the metal baseplate 200. The source, drain and gate terminals 210, 212, 214 may correspond to the source, drain, and gate electrodes 120, 122, 126, respectively, from the HEMT die 100 described with reference to Figure 1. In that case, the first dielectric layer 105 may form part of the main surface 208. Alternatively, the source, drain and gate terminals 210, 212, 214 may correspond to upper-level bond pads that are formed in an upper metallization layer (not shown in Figure 1) of the HEMT die 100 that is formed over the source, drain, and gate electrodes 120, 122, 126. In that case, an additional dielectric region (not shown in Figure. 1) may be provided on the HEMT die 100 in between the source, drain, and gate electrodes 120, 122, 126 and the upper-level bond pads which form the source, drain and gate terminals 210, 212, 214. The first and second HEMT dies 100 each comprise rear surface 216 opposite from the main surface 208. The rear surface 216 of the first and second HEMT dies 100 faces and is attached to the metal baseplate 200. This attachment may be a direct attachment. The first and second HEMT dies 100 may be attached using an adhesive such as tape, glue, epoxy, solder, etc. The rear surfaces 216 of the first and second HEMT dies 100 are electrically inactive. As explained above, the lateral device concept in combination with the substrate configuration of the HEMT dies 100 creates the electrically inactive rear side of the devices. The rear surfaces 216 of the first and second HEMT dies 100 may correspond to the rear side 115 of the semiconductor substrate 102 of the device from Figure 1 or may correspond to a surface of another layer that is formed on the rear side 115 of the semiconductor substrate 102 and is electrically isolated from the active channel region 101.

Referring to Figs. 2C and 2D, planar metal plates 218 are attached to the terminals of the first HEMT die 100 and the second HEMT die 100. The planar metal plates 218 may comprise or be plated with any of the following: Ni, Cu, Al, Ag, Au, Pd, Pt. The planar metal plates 218 can be provided from an undisturbed planar sheet metal that is similar or identical to a metal sheet used to form a package lead frame. This metal sheet can be cut to create the different geometries needed for particular bond pad configuration and/or die configuration.

One of the planar metal plates 218 is attached to each of the source, drain and gate terminals 210, 212, 214 from the first and second HEMT dies 100. This may be done using an electrically conductive attachment material, e.g., solder, sinter, conductive glue, etc. According to the depicted embodiment, one of the planar metal plates 218 is attached to both the drain terminal 212 from the first HEMT die 100 and the source terminal 210 from the second HEMT die 100. Apart from that, one of the planar metal plates 218 is attached individually to the source terminal 210 from the first HEMT die 100, to the drain terminal 212 from the second HEMT die 100, to the gate terminal 214 from the first HEMT die 100, and to the gate terminal 214 from the second HEMT die 100. This connection scheme creates a half-bridge circuit, wherein the first HEMT die 100 corresponds to the high-side switch of the half-bridge circuit and the second HEMT die 100 corresponds to the low-side switch of the half-bridge circuit.

Referring to Figs. 2E and 2F, vertical connection elements 220 are mounted on the planar metal plates 218. The vertical connection elements 220 are electrically conductive structures that are used to provide externally accessible package terminals of the device. Stated another way, the vertical connection elements 220 provide the necessary vertical extension to reach the outside of the encapsulant material, with the planar metal plates 218 serving as mounting platforms that facilitate the usage of the vertical connection elements 220 without using bond wires. The vertical connection elements 220 may comprise or be plated with any of the following: Ni, Cu, Al, Ag, Au, Pd, Pt. As shown, multiple vertical connection elements 220 may be provided on one of the planar metal plates 218, thereby improving connectivity and lowering the electrical resistance of this terminal connection.

In the depicted embodiment, the vertical connection elements 220 are configured as pin-rivets, i.e., cylindrical structures that comprise an interior opening for the insertion of a cylindrical metal pin. More generally, the vertical connection elements 220 can have any of a wide variety of geometries and/or configurations. For example, the vertical connection elements 220 may comprise press-fit pins, other types of stanchion shaped structures that may be affixed directly to the planar metal plates 218, or planar metal leads that may protrude out from an encapsulant body.

Referring to Figs. 2G and 2H, after forming the bond wire-free connections comprising the vertical connection elements 220 and the planar metal plates 218, an encapsulant body 222 is formed that encapsulates the first HEMT die 100 and the second HEMT die 100. The encapsulant body 222 may comprise any electrically insulating material used in electronics applications to protect semiconductor dies and dielectrically isolate components at different electrical potentials from one another. According to an embodiment, the encapsulant body 222 is a mold compound comprising epoxy, thermosetting plastic, polymer, etc. The encapsulant body 222 is formed by molding process such as injection molding, transfer molding, compression molding, etc. As can be seen, the outer ends of the vertical connection elements 220 are exposed from the encapsulant body 222. The vertical connection elements 220 therefore provide package terminals that are connected with the source, drain and gate terminals 210, 212, 214 from the first and second HEMT dies 100 via a bond wire-free connection.

Referring to Figure 3, selected method steps in a method of forming a semiconductor package by a bond wire-free connection technique are shown, according to another embodiment. In this case, the bond wire-free is effectuated by planar metal leads 224 that are attached directly to the terminals of the first and second HEMT dies 100 and protrude out from the encapsulant body 222. The first and second HEMT dies 100 are arranged in a sandwich configuration with the first and second HEMT dies 100 overlapping with one another and with the planar metal leads 224 being arranged in between the main surfaces 208 of the first and second HEMT dies 100.

Referring to Figs. 3A and 3B a first HEMT die 100 is mounted on a first metal baseplate 200 with the main surface 208 of the first HEMT die 100 facing away from the first metal baseplate 200. As the first metal baseplate 200 is only used to accommodate a single die in this case, it can be dimensioned accordingly.

Referring to Figs. 3C and 3D, planar metal leads 224 are attached to the source terminal 210 of the first HEMT die 100 and the gate terminal 210 of the first HEMT die 100. The planar metal leads 224 may be attached using an electrically conductive attachment material, e.g., solder, sinter, conductive glue. The planar metal leads 224 may comprise or be plated with any of the following: Ni, Cu, Al, Ag, Au, Pd, Pt. The planar metal leads 224 differ from the planar metal plates 218 from the previously described embodiment in that they are shaped to protrude out of the encapsulant body 222.

Referring to Figs. 3E and 3F, a second HEMT die 100 is mounted on a second metal baseplate 200 with the main surface 208 of the second HEMT die 100 facing away from the second metal baseplate 200. The second HEMT die 100 may be identical to the first HEMT die 100 except that the location of the gate terminal 214 is disposed on an opposite side of an axis of symmetry to facilitate the mating of the two assemblies described below. As the second metal baseplate 200 is only used to accommodate a single die in this case, it can be dimensioned accordingly.

Referring to Figs. 3G and 3H, planar metal leads 224 are attached to the source terminal 210 of the second HEMT die 100, the drain terminal 212 of the second HEMT die 100, and the gate terminal 214 of the second HEMT die 100. The planar metal leads 224 may be attached using an electrically conductive attachment material, e.g., solder, sinter, conductive glue. The planar metal lead 224 that is attached to the source terminal 210 of the second HEMT die 100 is substantially thicker than the other planar metal leads 224 attached the first HEMT die 100 and the HEMT die 100, e.g., greater than twice this thickness.

Referring to Figs. 3I and 3J, the assembly comprising the second HEMT die 100 is arranged over the assembly comprising the first HEMT die 100 such that the main surface 208 of the second HEMT die 100 faces the main surface 208 of the first HEMT die 100. In this step, the assembly comprising the second HEMT die 100 is rotated 180 degrees relative to the vertical axis V_{A} identified in Fig. 3H. As a result, the two assemblies are mated such that the planar metal lead 224 that is attached to the drain terminal 212 of the first HEMT die 100 contacts the source terminal 210 of the second HEMT die 100 and such that the remaining planar metal leads 224 are arranged on the opposite side of the combined assembly. The planar metal lead 224 that is attached to the drain terminal 212 of the first HEMT die 100 may be electrically connected to the source terminal 210 of the second HEMT 202 by a conductive adhesive, e.g., solder, sinter, conductive glue, etc. Meanwhile, the remaining planar metal leads 224 on the opposite side of the assembly form independent conductive paths to each of: the source terminal 210 of the first HEMT die 100, the gate terminal 214 of the first HEMT die 100, the drain terminal 212 of the second HEMT die 100, and the gate terminal 214 of the second HEMT die 100. In the depicted embodiment, the increased thickness of the planar metal lead that 222 is attached to both the drain terminal 212 of the first HEMT die 100 and the source terminal 210 facilitates an electrical connection between these terminals while maintaining vertical clearance between the other independent electrical connections on the opposite side of the assembly. This represents just one way to achieve a half-bridge connection scheme with two assembles mated on top of one another. In other embodiments, the assembly may include a conductive spacer in the electrical connection between the drain terminal 212 of the first HEMT die 100 and the source terminal 210 of the second HEMT 202 and/or multiple planar metal leads 224 in the electrical connection between the drain terminal 212 of the first HEMT die 100 and the source terminal 210 of the second HEMT die 100 and/or an interposer structure in between the first and second HEMT dies 100.

As can be appreciated from a comparison of Figs. 3C and 3G, the planar metal leads 224 that form independent conductive paths to each of the source terminal 210 of the first HEMT die 100, the gate terminal 214 of the first HEMT die 100, the drain terminal 212 of the second HEMT die 100, and the gate terminal 214 of the second HEMT die 100 are geometrically configured such that when the two assemblies are mated together, each of these leads are laterally offset from one another, i.e., non-overlapping, and hence easily accessible. This is facilitated in part by the provision of the gate terminal 214 in two different locations in the first HEMT die 100 and the second HEMT die 100 as discussed above. Alternatively, an electrical interposer structure may be used to provide a similar arrangement wherein the two HEMT dies with identical gate terminal 214 arrangements are provided.

Referring to Figs. 3I and 3J, an encapsulant body 222 is formed that encapsulates the first and second HEMT dies 100. In the depicted embodiment, the first and second metal baseplates 200 remain exposed form the encapsulant body 222, thus providing dual side cooling capability. In other embodiments, one or both of these first and second metal baseplates 200 may remain covered by the encapsulant body 222.

In addition to the depicted embodiments, the embodiments disclosed herein include single die embodiments. In one example of a single die embodiment, the methods of Figures 2-3 may be practiced similarly, while omitting the second HEMT die 100 and corresponding elements attached thereto.

In addition to the depicted embodiments, the embodiments disclosed herein include embodiments comprising more than two dies, including any full-bridge and/or multiphase package configuration. In one example of an embodiment comprising more than two dies, a semiconductor package may comprise three of the assemblies comprising the first HEMT die 100 and the second HEMT die 100 mounted on a single metal baseplate 200 and connected in a half-bridge configuration as described above, wherein the planar metal plates 218 form parallel connections with the source terminals 210 of the three high-side switches and the drain terminals 212 of the three low-side switches, thus forming a three-phase bridge configuration. In another example of an embodiment comprising more than two dies, a semiconductor package may comprise two of the assemblies comprising the first HEMT die 100 and the second HEMT die 100 mounted on a single metal baseplate 200 and connected in a half-bridge configuration as described above, wherein the planar metal plates 218 form parallel connections with the source terminals 210 of the two high-side switches and the drain terminals 212 of the two low-side switches, thus forming a two-phase multi bridge configuration.

In addition to the depicted embodiments, the embodiments disclosed herein include an embodiment with a pair of HEMT dies 100 arranged on top of one another, e.g., as described in Figure 3, but with a single metal baseplate 200. In that case, the method of Figure 3 may be practiced similarly, while omitting the second baseplate 200 above the second HEMT die 100.

In addition to the depicted embodiments, the embodiments disclosed herein include an embodiment wherein the semiconductor package is implemented as a power module. In that case, the metal baseplate 200 can surrounded by a housing and the encapsulant 222 can correspond to a potting compound such as a silicone based dielectric gel that is initially flowed around the first and second HEMT dies 100 and subsequently hardened by a curing process.

Although the present disclosure is not so limited, the following numbered examples demonstrate one or more aspects of the disclosure.

The HEMT die 100 described herein can comprise a semiconductor substrate 102 comprising any combination of type III-V semiconductor materials capable of forming a two-dimensional charge carrier gas at a heterojunction between type III-V semiconductor materials of different bandgap. These type III-V semiconductor materials include binary III-V semiconductor materials such as Gallium nitride (GaN), gallium arsenide (GaAs), aluminium nitride (AIN), aluminium arsenide (AlAs), indium nitride (InN), indium arsenide (InAs), etc., and ternary or quarternary type III-V semiconductor materials such as aluminium gallium nitride (AlGaN), aluminium gallium arsenide (AlGaAs), indium gallium nitride (InGaN), indium aluminium gallium nitride (InAIGaN), etc.

As used herein, the phrase "type III-V semiconductor material" refers to a compound material that includes at least one Group III element, such as aluminum (Al), gallium (Ga), indium (In), and boron (B) and at least one Group IV element, such as nitrogen (N), phosphorous (P), and arsenic (As), and including but not limited to any of its alloys, such as aluminum gallium nitride (AlxGa(1-x)N), indium gallium nitride (InyGa(1-y)N), aluminum indium gallium nitride (AIxInyGa(1-x-y)N), gallium arsenide phosphide nitride (GaAsaPbN(1-a-b)), and aluminum indium gallium arsenide phosphide nitride (AlxInyGa(1-x-y)AsaPbN(1-a-b)), for example. Aluminum gallium nitride and AlGaN refers to an alloy described by the formula AlxGa(1-x)N, where 0 < x < 1.

Spatially relative terms such as "under," "below," "lower," "over," "upper" and the like, are used for ease of description to explain the positioning of one element relative to a second element. These terms are intended to encompass different orientations of the device in addition to different orientations than those depicted in the figures. Further, terms such as "first," "second," and the like, are also used to describe various elements, regions, sections, etc. and are also not intended to be limiting. Like terms refer to like elements throughout the description.

As used herein, the terms "having," "containing," "including," "comprising" and the like are open-ended terms that indicate the presence of stated elements or features, but do not preclude additional elements or features. The articles "a," "an" and "the" are intended to include the plural as well as the singular, unless the context clearly indicates otherwise.

With the above range of variations and applications in mind, it should be understood that the present invention is not limited by the foregoing description, nor is it limited by the accompanying drawings. Instead, the present invention is limited only by the following claims and their legal equivalents.

### Further examples:

Example 1 discloses a semiconductor package, comprising:
a metal baseplate;
first and second HEMT high electron mobility transistor dies each comprising a main surface with source, drain and gate terminals disposed thereon;
a plurality of metal package terminals; and
an encapsulant body of electrically insulating material,
wherein the first and second HEMT dies are mounted on the metal baseplate with the main surfaces from each of the first and second HEMT dies facing away from the metal baseplate,
wherein the encapsulant body encapsulates the first and second HEMT dies,
wherein outer ends from each of the metal package terminals are exposed from the encapsulant body, and
wherein each of the source, drain and gate terminals from the first and second HEMT dies is electrically connected via a bond wire-free connection to at least one of the metal package terminals.

Example 2 discloses the semiconductor package of example 1, wherein the first and second HEMT dies each comprise a rear surface opposite from the main surface that is electrically inactive, and wherein the rear surfaces from each of the first and second HEMT dies are directly attached to the metal baseplate.

Example 3 discloses the semiconductor package of example 2, wherein each of the first and second HEMT dies comprise an active channel region that conducts a lateral load current and an electrically insulating layer disposed between the active channel region and the rear surface that electrically isolates the active channel region from the rear surface.

Example 4 discloses the semiconductor package of any of the previous examples, further comprises a planar metal plate to each of the source, drain and gate terminals from the first and second HEMT dies.

Example 5 discloses the semiconductor package of example 4, further comprises vertical connection elements mounted on each of the planar metal plates.

Example 6 discloses the semiconductor package of example 4 or 5, wherein one of the planar metal plates is attached to both the drain terminal from the first HEMT die and the source terminal from the second HEMT die.

Example 7 discloses a semiconductor package, comprising:
a first metal baseplate;
first and second HEMT high electron mobility transistor dies each comprising a main surface with source, drain and gate terminals disposed thereon;
   a plurality of planar metal leads; and
an encapsulant body of electrically insulating material,
wherein the first HEMT die is mounted on the first metal baseplate with the main surface of the first HEMT die facing away from the first metal baseplate;
   wherein the second HEMT die is arranged over the first HEMT die with the main surface of the second HEMT die facing the main surface of the first HEMT die,
   wherein the encapsulant body encapsulates the first and second HEMT dies, and
   wherein outer ends from each of the planar metal leads are exposed from the encapsulant body, and
   wherein each of the source, drain and gate terminals from the first and second HEMT dies is electrically connected via a bond wire-free connection to at least one of the planar metal leads.

Example 8 discloses the semiconductor package of example 7, wherein the semiconductor package further comprises a second metal baseplate, wherein the second HEMT die is mounted on the second metal baseplate with the main surface of the second HEMT die facing away from the second metal baseplate.

Example 9 discloses the semiconductor package of example 7 or 8, wherein the first and second HEMT dies each comprise a rear surface opposite from the main surface that is electrically inactive, and wherein the rear surface from the first HEMT die is directly attached to the first metal baseplate, and wherein the rear surface from the second HEMT die is directly attached to the second metal baseplate.

Example 10 discloses the semiconductor package of any of examples 7 to 9, wherein each of the first and second HEMT dies comprise an active channel region that conducts a lateral load current and a layer of electrically insulating disposed below the active channel region that electrically isolates the active channel region from the rear surface.

Example 11 discloses the semiconductor package of any of examples 7 to 10, wherein the drain terminal from the first HEMT die overlaps with the source terminal from the second HEMT die, and wherein one of the planar metal leads is interposed between and electrically connected with the drain terminal from the first HEMT die and the source terminal from the second HEMT die.

Example 12 discloses a method of forming a semiconductor package, the method comprising:
providing a first metal baseplate;
providing a first HEMT die comprising a main surface with source, drain and gate terminals disposed thereon;
mounting the first HEMT die on the first metal baseplate with the main surface from the first HEMT die facing away from first metal baseplate;
providing a plurality of metal package terminal;
electrically connecting each of the source, drain and gate terminals from the first HEMT die via a bond wire-free connection to at least one of the metal package terminals; and
forming an encapsulant body of electrically insulating material that encapsulates the first HEMT die and exposes outer ends of the metal package terminals.

Example 13 discloses the method of example 12, wherein the first HEMT die comprises a rear surface opposite from the main surface that is electrically inactive, and wherein the rear surface from the first HEMT die is directly attached to the first metal baseplate.

Example 14 discloses the method of example 13, wherein the first HEMT die comprises an active channel region that conducts a lateral load current and an electrically insulating layer disposed between the active channel region and the rear surface that electrically isolates the active channel region from the rear surface.

Example 15 discloses the method of any of examples 12 to 14, further comprising:
providing a second HEMT die comprising a main surface with source, drain and gate terminals disposed thereon; and
electrically connecting each of the source, drain and gate terminals from the second HEMT die via a bond wire-free connection to at least one of the metal package terminals,
wherein the encapsulant body is formed to encapsulate the second HEMT die.

Example 16 discloses the method of example 15, further comprising:
mounting the second HEMT die on the first metal baseplate with the main surface from the second HEMT die facing away from the first metal baseplate.

Example 17 discloses the method of example 15 or 16, further comprising:
attaching a planar metal plate to each of the source, drain and gate terminals from the first and second HEMT dies; and
mounting one or more vertical connection elements on each of the planar metal plates.

Example 18 discloses the method of example 15, further comprising:
mounting the second HEMT die on a second metal baseplate with the main surface from the second HEMT die facing away from first metal baseplate; and
arranging the second HEMT die over the first HEMT die with the main surface of the second HEMT die facing the main surface of the first HEMT die.

Example 19 discloses the method of example 15 or 18, wherein providing the plurality of metal package terminals comprises providing a plurality of planar metal leads, and wherein the method comprises arranging the planar metal leads in between the first HEMT die and the second HEMT die and electrically connecting each of the source, drain and gate terminals from the first and second HEMT dies via a bond wire-free connection to at least one of the planar metal leads.

Example 20 discloses the method of example 19, wherein the drain terminal from the first HEMT die overlaps with the source terminal from the second HEMT die, and wherein one of the planar metal leads is interposed between and electrically connected with the drain terminal from the first HEMT die and the source terminal from the second HEMT die.

## Claims

1. A semiconductor package, comprising:
a metal baseplate (200);
first and second HEMT (high electron mobility transistor) dies (100) each comprising a main surface (208) with source (210), drain (212) and gate (214) terminals disposed thereon;
a plurality of metal package terminals; and
an encapsulant body (222) of electrically insulating material,
wherein the first and second HEMT dies (100) are mounted on the metal baseplate (200) with the main surfaces (208) from each of the first and second HEMT dies (100) facing away from the metal baseplate (200),
wherein the encapsulant body (222) encapsulates the first and second HEMT dies (100),
wherein outer ends from each of the metal package terminals are exposed from the encapsulant body (222), and
wherein each of the source (210), drain (212) and gate (214) terminals from the first and second HEMT dies (100) is electrically connected via a bond wire-free connection to at least one of the metal package terminals.

2. The semiconductor package of claim 1, wherein the first and second HEMT dies (100) each comprise a rear surface (216) opposite from the main surface (208) that is electrically inactive, and wherein the rear surfaces (216) from each of the first and second HEMT dies (100) are directly attached to the metal baseplate (200).

3. The semiconductor package of claim 2, wherein each of the first and second HEMT dies (100) comprise an active channel region (101) that conducts a lateral load current and an electrically insulating layer (117) disposed between the active channel region (101) and the rear surface (216) that electrically isolates the active channel region (101) from the rear surface (115, 216).

4. The semiconductor package of any of the previous claims, further comprises a planar metal plate (218) to each of the source (210), drain (212) and gate (214) terminals from the first and second HEMT dies (100).

5. The semiconductor package of claim 4, further comprises vertical connection elements (220) mounted on each of the planar metal plates (218).

6. The semiconductor package of claim 4 or 5, wherein one of the planar metal plates (218) is attached to both the drain terminal (212) from the first HEMT die (100) and the source terminal (210) from the second HEMT die (100).

7. A semiconductor package, comprising:
a first metal baseplate (200);
first and second HEMT (high electron mobility transistor) dies (100) each comprising
a main surface (208) with source (210), drain (212) and gate (214) terminals disposed thereon;
a plurality of planar metal leads (224); and
an encapsulant body (222) of electrically insulating material,
wherein the first HEMT die (100) is mounted on the first metal baseplate (200) with the main surface (208) of the first HEMT die (100) facing away from the first metal baseplate (200);
wherein the second HEMT die (100) is arranged over the first HEMT die (100) with the main surface (208) of the second HEMT die (100) facing the main surface (208) of the first HEMT die (100),
wherein the encapsulant body (222) encapsulates the first and second HEMT dies (100), and
wherein outer ends from each of the planar metal leads (224) are exposed from the encapsulant body (222), and
wherein each of the source (210), drain (212) and gate (214) terminals from the first and second HEMT dies (100) is electrically connected via a bond wire-free connection to at least one of the planar metal leads (224).

8. The semiconductor package of claim 7, wherein the semiconductor package further comprises a second metal baseplate (200), wherein the second HEMT die (100) is mounted on the second metal baseplate (200) with the main surface (208) of the second HEMT die (100) facing away from the second metal baseplate (200).

9. The semiconductor package of claim 7 or 8, wherein the first and second HEMT dies (100) each comprise a rear surface (216) opposite from the main surface (208) that is electrically inactive, and wherein the rear surface (216) from the first HEMT die (100) is directly attached to the first metal baseplate (200), and wherein the rear surface (216) from the second HEMT die (100) is directly attached to the second metal baseplate (200).

10. The semiconductor package of any of claims 7 to 9, wherein each of the first and second HEMT dies (100) comprise an active channel region (101) that conducts a lateral load current and a layer of electrically insulating disposed (117) below the active channel region (101) that electrically isolates the active channel region (101) from the rear surface (216).

11. The semiconductor package of any of claims 7 to 10, wherein the drain terminal (214) from the first HEMT die (100) overlaps with the source terminal (210) from the second HEMT die (100), and wherein one of the planar metal leads (224) is interposed between and electrically connected with the drain terminal (214) from the first HEMT die (100) and the source terminal (210) from the second HEMT die (100).

12. A method of forming a semiconductor package, the method comprising:
providing a first metal baseplate (200);
providing a first HEMT die (100) comprising a main surface (208) with source (210), drain (212) and gate (214) terminals disposed thereon;
mounting the first HEMT die (100) on the first metal baseplate (200) with the main surface (208) from the first HEMT die (100) facing away from first metal baseplate (200);
providing a plurality of metal package terminal;
electrically connecting each of the source (210), drain (212) and gate (214) terminals from the first HEMT die (100) via a bond wire-free connection to at least one of the metal package terminals; and
forming an encapsulant body (222) of electrically insulating material that encapsulates the first HEMT die (100) and exposes outer ends of the metal package terminals.

13. The method of claim 12, wherein the first HEMT die (100) comprises a rear surface (216) opposite from the main surface (208) that is electrically inactive, and wherein the rear surface (216) from the first HEMT die (100) is directly attached to the first metal baseplate (200).

14. The method of claim 13, wherein the first HEMT die (100) comprises an active channel region (101) that conducts a lateral load current and an electrically insulating layer (117) disposed between the active channel region (101) and the rear surface (216) that electrically isolates the active channel region (101) from the rear surface (115, 216).

15. The method of any of claims 12 to 14, further comprising:
providing a second HEMT die (100) comprising a main surface (208) with source (210), drain (212) and gate (214) terminals disposed thereon; and
electrically connecting each of the source (210), drain (212) and gate (214) terminals from the second HEMT die (100) via a bond wire-free connection to at least one of the metal package terminals,
wherein the encapsulant body (222) is formed to encapsulate the second HEMT die (100).

16. The method of claim 15, further comprising:
mounting the second HEMT die (100) on the first metal baseplate (200) with the main surface (208) from the second HEMT die (100) facing away from the first metal baseplate (200).

17. The method of claim 15 or16, further comprising:
attaching a planar metal plate (218) to each of the source (210), drain (212) and gate (214) terminals from the first and second HEMT dies (100); and
mounting one or more vertical connection elements (220) on each of the planar metal plates (218).

18. The method of claim 15, further comprising:
mounting the second HEMT die (100) on a second metal baseplate (200) with the main surface (208) from the second HEMT die (100) facing away from first metal baseplate (200); and
arranging the second HEMT die (100) over the first HEMT die (100) with the main surface (208) of the second HEMT die (100) facing the main surface (208) of the first HEMT die (100).

19. The method of claim 15 or 18, wherein providing the plurality of metal package terminals comprises providing a plurality of planar metal leads (224), and wherein the method comprises arranging the planar metal leads (224) in between the first HEMT die (100) and the second HEMT die (100) and electrically connecting each of the source (210), drain (212) and gate (214) terminals from the first and second HEMT dies (100) via a bond wire-free connection to at least one of the planar metal leads (224).

20. The method of claim 19, wherein the drain terminal (212) from the first HEMT die (100) overlaps with the source terminal (210) from the second HEMT die (100), and wherein one of the planar metal leads (224) is interposed between and electrically connected with the drain terminal (212) from the first HEMT die (100) and the source terminal (210) from the second HEMT die (100).
